# EUROPEAN PATENT APPLICATION

(11) **EP 2 031 646 A1**
(43) Date of publication of application: **04.03.2009**
(21) Application number: 07742028.9
(22) Date of filing: 20.04.2007
(51) Int. Cl.: H01L 21/304, B01J 19/08, B08B 3/02, B08B 5/00, B08B 7/00, G03F 7/42, H01L 21/306, H01L 21/3065, H05H 1/24

(54) **TREATING APPARATUS, METHOD OF TREATING AND PLASMA SOURCE**

(30) Priority: 22.06.2006 JP 2006172388; 19.07.2006 JP 2006196931
(71) Applicant: River Bell Co., Taito-ku, Tokyo 110-0016 (JP); TOKYO INSTITUTE OF TECHNOLOGY, Tokyo 1528550 (JP)
(72) Inventor: KANEGAE, Masatomo, Tokyo 192-0919 (JP); OKINO, Akitoshi, Kanagawa 226-0026 (JP); MIYAHARA, Hidekazu, Kanagawa 226-0026 (JP)
(74) Representative: Grünecker, Kinkeldey, Stockmair & Schwanhäusser Anwaltssozietät
(86) International application number: PCT/JP2007/058593
(87) International publication number: WO 2007/148470

(57) **Abstract**

[PROBLEMS]

A processing apparatus and a processing method that shorten a lead time and are more reliable than before in respect of the processing performance are provided.

[MEANS FOR SOLVING PROBLEMS]

The processing apparatus has a chamber, a retaining means provided in the chamber for retaining a workpiece, an active atom supplying means for supplying an active atom into the chamber, and a chemical supplying means for supplying a chemical into the chamber. For the surface of the workpiece, dry processing by the active atom supplied from the active atom supplying means and wet processing by the chemical supplied from the chemical supplying means are performed.

## Description

### TECHNICAL FIELD

The present invention relates to a processing apparatus and a processing method for processing the surface of a workpiece. In particular, the invention relates to a processing apparatus and a processing method used in manufacturing steps of a semiconductor substrate such as silicon, a semiconductor memory or an integrated circuit using a semiconductor substrate, or a display unit formed on a glass substrate as a workpiece. Further, the invention relates to a plasma source for generating plasma, a processing apparatus for processing a workpiece by using plasma, and a processing method thereof.

### BACKGROUND ART

In manufacturing steps of a semiconductor memory and an integrated circuit using a silicon wafer, multiple surface processing such as cleaning the substrate surface, removing the resist, and etching the coating film are performed by wet processing.

Wet cleaning of the substrate surface is often performed on the basis of RCA cleaning in combination with cleaning steps by the following chemicals. A mixture of NH₄OH/H₂O₂/H₂O (Ammonium hydroxide/hydrogen Peroxide/water Mixture, hereinafter referred to as "APM") can remove particles on the surface by oxidizing the surface by hydrogen peroxide solution and removing a resultant oxidized film by ammonia. A mixture of HCl/H₂O₂/H₂O (Hydrochloric acid/hydrogen Peroxide/water Mixture, hereinafter referred to as "HPM") can remove a heavy metal (Fe, Ni, Cr, Cu or the like) and the like attached to the surface by dissolving the heavy metal or the like by HCL. A mixture of H ₂SO₄/H₂O₂/H₂O (Sulfuric acid/hydrogen Peroxide/water Mixture, hereinafter referred to as "SPM") can remove an organic matter attached to the substrate surface by strong oxidative power of sulfuric acid and hydrogen peroxide solution. A mixture of HF/H₂O/H₂O (hydroFluoric acid/hydrogen Peroxide/water Mixture, hereinafter referred to as "FPM") or a mixture of HF/H₂O (Diluted HydroFluoric acid, hereinafter referred to as "DHF") can remove an unnecessary natural oxidized film on the silicon surface. For example, a cleaning step with APM heated up to 75 to 85 deg C is performed for the silicon surface to remove particles on the surface. After that, a cleaning step by DHF is performed to remove an unnecessary natural oxidized film on the surface.

For a resist, first, dry cleaning using oxygen plasma or oxygen atoms is performed. After that, the resist is removed by wet cleaning by the foregoing SPM. In some cases, the resist may be removed by using a solution in which ozone gas O₃ is dissolved in H₂SO₄ solution.

Wet-etching a coating film formed on the substrate surface includes, for example, a step of removing a silicon nitride film. In manufacturing a semiconductor integrated circuit device, to separate respective MOS transistors from each other, selective oxidation method with the use of a silicon nitride film as a mask is used. After the oxidation step, the silicon nitride film is no longer necessary and thus is removed. However, the surface of the silicon nitride film is slightly oxidized in the oxidation step, and thus the etching processing is somewhat tangled. In the etching processing, first, the oxidized film on the silicon nitride film is wet-etched by a hydrofluoric acid solution. Next, the resultant is dipped into a cleaning bath containing heat phosphoric acid (H₃PO₄ solution) at 160 deg C for about 40 minutes to remove the silicon nitride film. Finally, an oxidized film as a foundation of the silicon nitride film is wet-etched by the hydrofluoric acid solution.

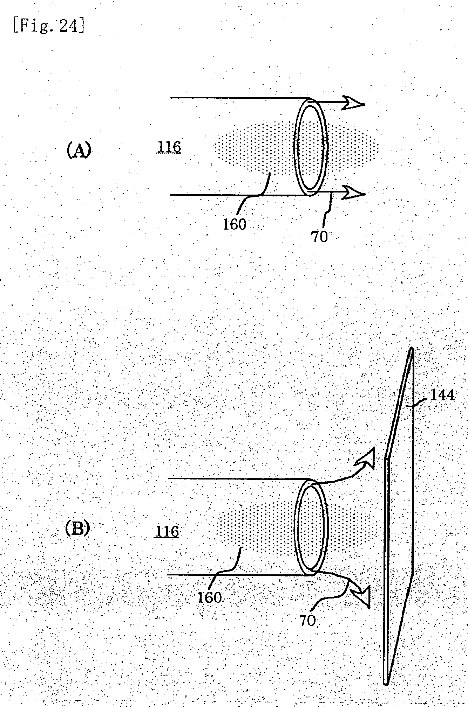

In a plasma source for generating plasma used in dry processing such as dry cleaning, for cooling the plasma source, there are the following existing methods. One thereof is a method to circulate cooling water or cooling gas. The other thereof is a method in which cooling gas 70 is erupted as shown in Fig. 24A, for example. The cooling gas 70 surrounds plasma 160 transferred in front of a plasma generating means 116. As shown in Fig. 24B, when a workpiece 144 desired to be processed is arranged in front of the plasma 160 and the cooling gas 70 is erupted, the cooling gas 70 is spread, and the plasma 160 is arranged in the spread cooling gas 70. In this case, the cooling gas 70 is mixed in the plasma 160 due to crosscurrent and diffusion. When the cooling gas 70 is not erupted or erupted in other direction, the surrounding atmospheric gas is mixed in the plasma 160 to decrease the purity of the plasma 160.

[Patent Literature 1] Japanese Patent Unexamined Publication 2005-31020
[Patent Literature 2] Japanese Patent Unexamined Publication 2003-194723

### DISCLOSURE OF THE INVENTION

### PROBLEMS TO BE RESOLVED BY THE INVENTION

In the past, in a resist removal step, the following 2 steps have been necessitated. That is, dry cleaning using oxygen and wet cleaning by SPM has been necessitated. However, the wet cleaning by SPM takes a long time, and thus the lead time is long. In particular, in manufacturing steps of a semiconductor device, when doping processing using a resist is performed, the resist surface is hardened and thus it is necessary to take several tens of minutes to remove the resist. Further, there is a possibility that while a workpiece is transferred from a dry cleaning apparatus to a wet cleaning apparatus, the workpiece surface is contaminated, being attached with metal atoms and molecular contamination.

APM, HPM, SPM, and FPM used in a cleaning step are all mixed with hydrogen peroxide (H₂O₂). Hydrogen peroxide functions as an oxidant in the aqueous solution, and improves the cleaning effect by acid or alkali. However, hydrogen peroxide is extremely unstable and thus easily decomposed. Therefore, it is difficult to control the concentration thereof in the chemical. In particular, these chemicals are often used being heated. The higher the temperature becomes, the faster the decomposition velocity of hydrogen peroxide becomes. In that case, it is harder to control the concentration thereof, and the precision of the cleaning ability becomes unstable.

The invention has been achieved in light of the above-described problems. A first object of the invention is to provide a processing apparatus and a processing method that shorten a lead time and are more reliable than before with respect to the processing performance. A second object of the invention is to provide a processing apparatus and a processing method that can improve performance or reliability of a semiconductor device.

A third object of the invention is to provide a processing apparatus and a processing method that use plasma mixed with little unnecessary gas, and a plasma source. Further, a fourth object of the invention is to provide a processing apparatus and a processing method that use an interaction between/among all, 2, or 3 of plasma, gas, liquid, and mist. Furthermore, a fifth object of the invention is to provide a processing apparatus and a processing method that use plasma, gas, liquid, and mist at the same time or alternately.

### MEANS OF SOLVING THE PROBLEMS

In order to achieve the aforementioned object, a processing apparatus according to a first aspect of the invention includes a chamber, a retaining means provided in the chamber for retaining a workpiece, an active atom supplying means for supplying an active atom into the chamber, and a chemical supplying means for supplying a chemical into the chamber, wherein dry processing by the active atom supplied from the active atom supplying means and wet processing by the chemical supplied from the chemical supplying means are performed for a surface of the workpiece.

In the processing apparatus according to the first aspect of the invention, the active atom supplying means preferably supplies the active atom into the chamber at an ambient pressure.

Further, in the processing apparatus according to the first aspect of the invention, the retaining means may rotate the retained workpiece, and a supply port of the active atom supplying means may be arranged opposite to the surface of the workpiece and may be provided movably in the direction of a radius from a rotation center of the workpiece. In this case, the supply port of the active atom supplying means and a supply port of the chemical supplying means may be integrated.

Further, in the processing apparatus according to the first aspect of the invention, a supply port of the active atom supplying means may be opposite to the surface of the workpiece, and may have an area equal to or more than an area of the workpiece. Further, the retaining means may be provided capable of retaining a plurality of workpieces, and may be provided capable of dipping the plurality of workpieces in the chemical.

Further, in the processing apparatus according to the first aspect of the invention, the chemical may contain sulfuric acid, and the active atom may contain a hydrogen atom or an oxygen atom. Otherwise, the chemical may contain ammonium hydroxide, hydrochloric acid, sulfuric acid, or hydrofluoric acid, and the active atom may contain an oxygen atom. Otherwise, the workpiece may contain a semiconductor on a processing surface, and the active atom may contain a hydrogen atom.
Otherwise, the chemical may contain phosphoric acid, and the active atom may contain a fluorine atom. Further, the workpiece may have a resist film on a processing surface, the active atom may contain a hydrogen atom or an oxygen atom, and the resist film of the workpiece may be removed.

Further, in the processing apparatus according to the first aspect of the invention, the active atom supplying means preferably generate the active atom by using inductively coupled plasma method or microwave plasma method.

In a processing method according to a first aspect of the invention, dry processing by an active atom supplied from an active atom supplying means and wet processing by a chemical supplied from a chemical supplying means are performed at the same time or sequentially for a surface of a workpiece retained in a chamber.

Further, in the processing method according to the first aspect of the invention, the dry processing is preferably performed at an ambient pressure.

Further, in the processing method according to the first aspect of the invention, it is possible that while the chemical supplied from the chemical supplying means is supplied for a whole surface of the workpiece, the active atom supplied from the active atom supplying means is supplied for part of the surface of the workpiece.

Further, in the processing method according to the first aspect of the invention, the active atom may be supplied by moving a supply port of the active atom supplying means from a rotation center of the workpiece in the direction of a radius, while the workpiece is rotated.

Further, in the processing method according to the first aspect of the invention, the workpiece may be dipped in the chemical supplied from the chemical supplying means in the chamber, and the active atom may be supplied into an atmosphere in the chamber while the chemical is drained.

Further, in the processing method according to the first aspect of the invention, the chemical may contain sulfuric acid, and the active atom may contain a hydrogen atom or an oxygen atom. Otherwise, the chemical may contain ammonium hydroxide, hydrochloric acid, sulfuric acid, or hydrofluoric acid, and the active atom may contain an oxygen atom. Otherwise, the workpiece may contain a semiconductor on a processing surface, and the active atom may contain a hydrogen atom. Otherwise, the chemical may contain phosphoric acid, and the active atom may contain a fluorine atom. Further, the workpiece may have a resist film on a processing surface, the active atom may contain a hydrogen atom or an oxygen atom, and the resist film of the workpiece may be removed.

A plasma source according to an aspect of the invention includes a plasma generating section for generating plasma and a liquid supplying section for forming a liquid curtain, wherein the liquid supplying section covers at least part of the plasma generated by the plasma generating section with the liquid curtain.

A processing apparatus according to a second aspect of the invention includes a plasma generating section for generating plasma, a liquid supplying section for covering at least part of the plasma generated in the plasma generating section with a liquid curtain, and a retaining section arranged opposite to the liquid supplying section for retaining a workpiece, wherein the workpiece retained by the retaining section is processed by the plasma covered with the liquid curtain.

In a processing method according to a second aspect of the invention, liquid or mist is supplied into a liquid curtain, plasma is formed in the liquid curtain, and thereby a workpiece is processed.

In a processing method according to a third aspect of the invention, a workpiece is provided with dry processing by plasma covered with a liquid curtain, and the workpiece is provided with wet processing by liquid or mist.

### EFFECT OF THE INVENTION

According to the foregoing aspects of the invention, the dry processing and the wet processing can be performed at the same time. Therefore, the lead time can be shortened. Further, contamination on the workpiece is decreased, and thus the performance or the reliability of the semiconductor device can be improved. Furthermore, since the surface of the workpiece can be precisely controlled, the manufacturing precision can be improved and thereby the reliability and the manufacturing yield can be improved. In addition, according to the foregoing aspects of the invention, effects described in the following DETAILED DESCRIPTION OF THE PREFERRED EMBODIMENT can be obtained.

Further, according to the foregoing aspects of the invention, the plasma is surrounded by the liquid curtain to block gas, and therefore high purity processing is enabled. Furthermore, the following usable effects can be obtained. That is, a sample can be easily and simply cooled. Further, the wet processing and the dry processing can be performed for a workpiece sequentially, at the same time, or chronologically. Furthermore, the amount of plasma gas used can be decreased, plasma can be stabilized, a plasma torch can be lengthened, and the shape of a cooling torch section can be formed simply and inexpensively.

### BRIEF DESCRIPTION OF THE DRAWINGS

FIG. 1 is a view showing an embodiment of a processing apparatus of the invention;
FIG. 2 is a view showing an embodiment of a retaining means;
FIG. 3 is a view showing another embodiment of the retaining means;
FIG. 4 is a view showing an embodiment of an active atom supplying means and a chemical supplying means;
FIG. 5 is a view showing another embodiment of the active atom supplying means and the chemical supplying means;
FIG. 6 is a view showing another embodiment of the processing apparatus of the invention;
FIG. 7 is a view showing still another embodiment of the processing apparatus of the invention;
FIG. 8 is a view showing still another embodiment of the processing apparatus of the invention;
FIGS. 9A and 9B are views showing still another embodiment of the processing apparatus of the invention;
FIGS. 10a and 10b are views for explaining resist removal effect by an active oxygen atom;
FIGS. 11a to 11c are views for explaining resist removal effect by an active oxygen atom;
FIGS. 12a to 12c are views for explaining resist removal effect by an active oxygen atom;
FIGS. 13a to 13c are views for explaining resist removal effect by a hydrogen oxygen atom;
FIG. 14a shows the etching velocity of a resist when the active hydrogen atom is used, and FIG. 14b shows the etching velocity of a resist when the active oxygen atom is used;
FIG. 15 is a schematic view of a plasma source that forms a liquid curtain;
FIG. 16 is an explanation view of a plasma source including an opposing member arranged opposite to a discharge port of liquid;
FIGS. 17A to 17G are schematic views of an end of a liquid supplying section;
FIGS. 18A to 18J are schematic views of other plasma sources;
FIGS. 19A to 19D are schematic views of other plasma sources;
FIG. 20 is a photograph of a liquid curtain when gas is not introduced from a plasma generating section;
FIG. 21 is a photograph of a liquid curtain when gas is introduced from the plasma generating section;
FIG. 22 is an explanation view of a processing apparatus using a plasma source;
FIG. 23 is a flowchart of a processing method using a plasma source; and
FIGS. 24A and 24B are explanation views of a plasma source using existing cooling gas.

### BEST MODE FOR CARRYING OUT THE INVENTION

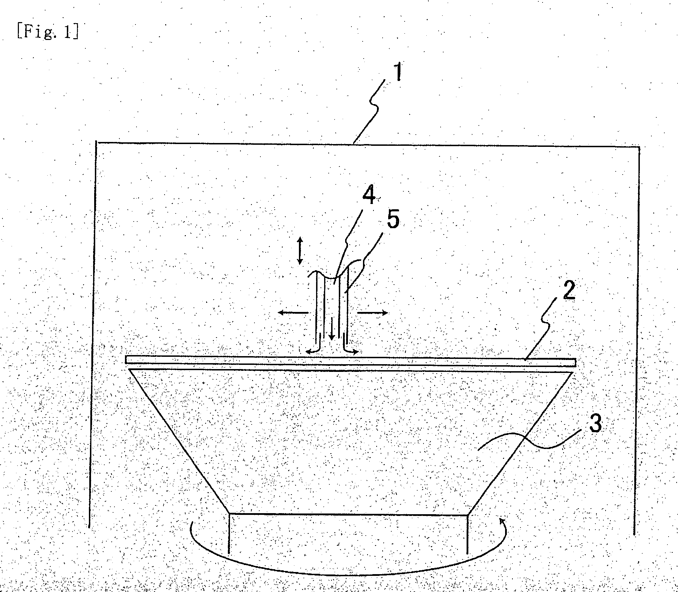

A processing apparatus shown in FIG. 1 has a chamber 1, a retaining means 3 for retaining a workpiece 2, an active atom supplying means 4, and a chemical supplying means 5. Dry processing can be performed for the surface of the workpiece 2 by supplying active atoms from the active atom supplying means 4 into the chamber 1. Wet processing can be performed for the surface of the workpiece 2 by supplying a chemical from the chemical supplying means 5 into the chamber 1. Further, the processing apparatus preferably has a ventilating means and a chemical draining means.

In the chamber 1, the dry processing and the wet processing are performed. The chamber 1 has an unshown carry-in port and an unshown carry-out port for the workpiece 2. The space of the chamber 1 is preferably separated from outside at least during processing, in order to prevent the active atoms and gas generated by the dry processing or the wet processing from outflowing outside or to prevent contamination from being mixed in the chamber 1. However, the chamber 1 may be opened according to the processing.

Further, the chamber 1 is preferably ventilated by the ventilating means, in order to prevent gas supplied into the chamber 1 and gas generated by processing from outflowing outside. The pressure in the chamber 1 is preferably from the ambient pressure (normal pressure) to low vacuum (100 Pa or more), and more preferably the ambient pressure. In the dry processing, in general, when the pressure is low, plasma can be generated more stably at a low electric power. Meanwhile, in the wet processing, when the pressure is low, the evaporation amount of the chemical is increased, and thus the composition ratio of the chemical is changed or the consumption amount of the chemical is increased. Further, in the view of lead times of the dry processing and the wet processing, when the pressure is low, it takes a good amount of time to return from the reduced pressure or the reduced pressure state to the ambient pressure, resulting in long processing time. Therefore, in the processing apparatus of the invention, processing is preferably performed at a pressure from the ambient pressure to low vacuum (100 Pa or more), and more preferably at the ambient pressure (normal pressure).

The workpiece 2 is provided with the dry processing by the active atoms supplied from the active atom supplying means 4 and the wet processing by a liquid supplied from the chemical supplying means 5. As the workpiece 2, for example, a semiconductor substrate itself such as silicon, a semiconductor substrate on which various films are layered, or a display unit formed on a glass substrate can be cited.

The retaining means 3 retains the workpiece 2 in the chamber 1. The retaining means 3 may be contacted with the workpiece 2, or floats the workpiece 2. The retaining means 3 may mount the workpiece 2 thereon. Otherwise, the retaining means 3 may retain a plurality of workpieces 2 by batch method. When the retaining means 3 can rotate the workpiece 2 mounted thereon, uniform processing can be performed for the surface of the workpiece 2.

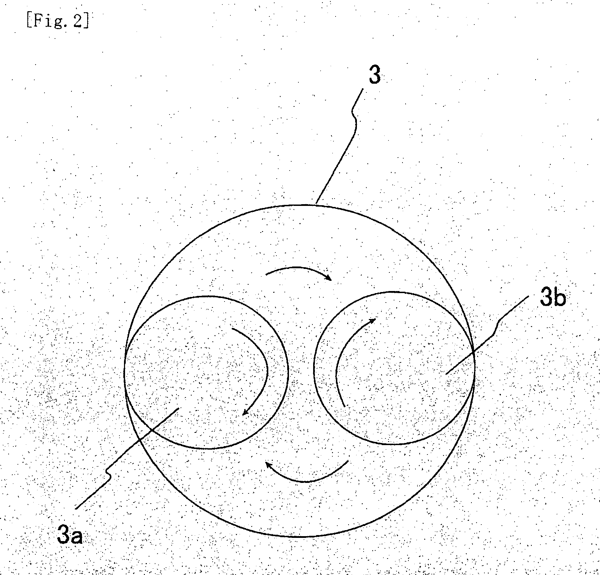

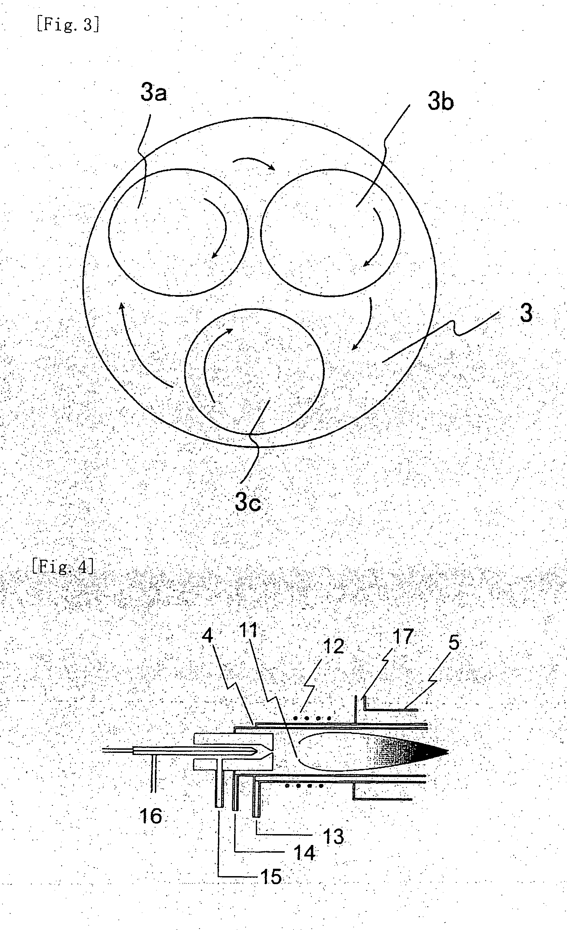

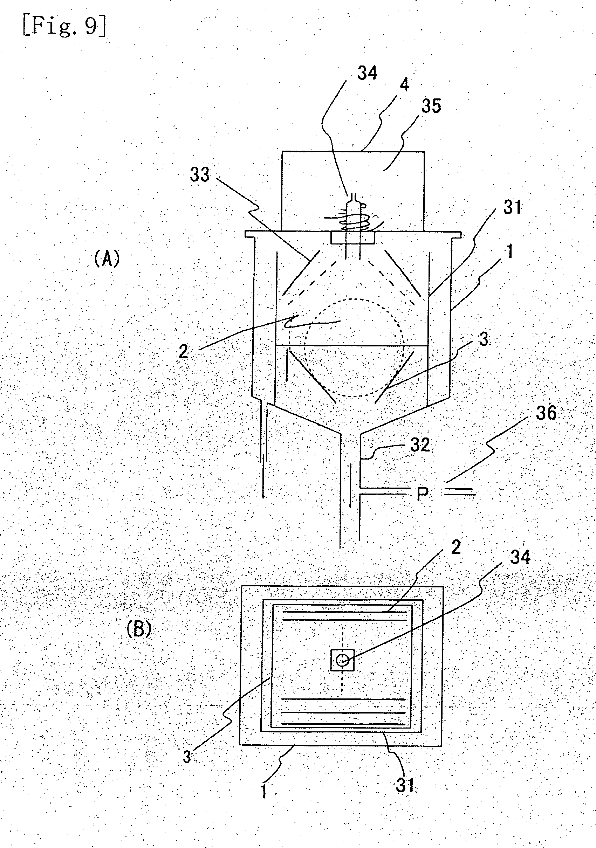

FIG. 2 and FIG. 3 are plan views of the retaining means 3 in other embodiments respectively. In FIG. 2, 2 workpieces 2 can be mounted in positions 3a, 3b of the retaining means 3. The retaining means 3 can make each workpiece 2 rotate on its axis, and can revolve itself and the workpieces 2 as a whole. In FIG. 3, 3 workpieces 2 can be mounted in positions 3a, 3b, 3c of the retaining means 3. The retaining means 3 can make each workpiece 2 rotate on its axis, and can revolve itself and the workpieces 2 as a whole. In the respective positions 3a to 3c, the same processing may be performed to improve the productivity. Otherwise, in the respective positions 3a to 3c, processing different from each other may be performed to make it possible to address multiple steps. The retaining means 3 may only make each workpiece 2 rotate on its axis and not revolve itself and the workpiece 2 as a whole. The retaining means 3 may be a receiver jig type retaining means as shown in FIGS. 9A and 9B.

The active atom supplying means 4 supplies active atoms. The active atom supplying means 4 is preferably a means for generating the active atoms by plasma, and is preferably a means for generating the active atoms at a pressure from the ambient pressure to low vacuum (100 Pa or more), and is more preferably a means for generating the active atoms at the ambient pressure. For example, the active atoms can be generated at the ambient pressure by using inductively coupled plasma method, microwave plasma method, or plasma jet generation method. In inductively coupled plasma method and microwave plasma method, plasma is generated by using electrodeless discharge. Therefore, it is possible to prevent contamination due to a metal generated from an electrode. In result, the processing reliability can be improved.

In this embodiment, electrically charged particles in plasma are not used, but the active atoms generated in the plasma are used. Therefore, processing can be performed without damaging the workpiece surface by charge. In the invention, the plasma includes both a state that most atoms are ionized and a state that most atoms are neutral particles and some atoms are ionized.

In FIG. 1, a supply port of the active atom supplying means 4 is arranged opposite to the surface of the workpiece 2. The supply port is provided movably from the rotation center of the workpiece 2 in the direction of the radius. The active atoms are supplied while the workpiece 2 is rotated and the supply port of the active atom supply means 4 is moved from the rotation center of the workpiece 2 in the direction of the radius. Thereby, the active atoms can be supplied for the whole area of the workpiece 2.

The chemical supply means 5 supplies a chemical. In FIG. 1, the chemical supply means 5 is provided movably. However, as long as the chemical can be supplied for the whole surface of the workpiece 2, the chemical supply means 5 is not necessarily provided movably. As the chemical, various types of acids, alkalis, natural solutions, alcohols, pure water, or mixed solutions thereof can be used. The chemical supply means can have a heating means for heating the chemical to be supplied.

Further, the active atom supplying means 4 of FIG. 1 is integrated with the chemical supplying means 5. A chemical eruption port of the chemical supplying means 5 is arranged around the active atom supplying means 4. Therefore, the active atom supplying means 4 and the chemical supplying means 5 can be moved at the same time. Further, a plasma torch (plasma source) can be cooled by a chemical. When the chemical eruption port of the chemical supplying means 5 is arranged around the opening of the active atom supplying means 4, the after-mentioned liquid curtain can be formed by the erupted chemical.

FIG. 4 is a schematic view of the plasma torch (plasma source) for generating plasma and discharging active atoms by inductively coupled plasma method as an embodiment of the active atom supplying means 4. In the plasma torch (plasma source), a coil 12 is arranged around a nozzle 11. The plasma torch (plasma source) has a cooling gas piping 13 for cooling the nozzle 11, a first gas piping 14, a second gas piping 15, and a third gas piping 16. Further, the chemical supplying means 5 is arranged around the nozzle 11. A chemical is supplied from a chemical port 17.

In the plasma torch (plasma source), when high frequency is applied to the coil 12, plasma gas or carrier gas supplied from one or a plurality of the first to the third gas piping 14, 15, 16 into the nozzle can be changed into plasma, and active atoms activated by the plasma can be discharged from the supply port at the end of the nozzle 11. In Patent literatures 1 and 2, descriptions are given of a plasma torch by inductively coupling plasma method. By the inductively coupling plasma method, high purity active atoms can be stably supplied even at the ambient pressure. When a microwave supplying means is provided instead of the coil 12 of FIG. 2 to generate plasma by microwave, the active atom supplying means 4 by microwave supplying method can be structured.

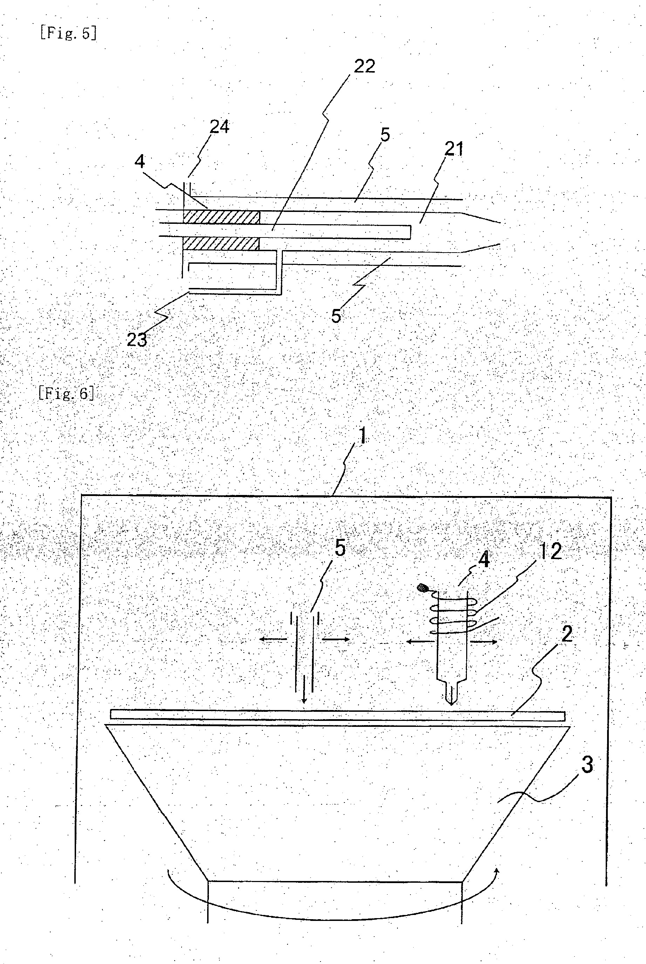

FIG. 5 is a schematic view of a plasma torch for generating plasma and discharging active atoms by plasma jet method using electrode discharge as another embodiment of the active atom supplying means 4. In the plasma torch, an electrode 22 is arranged in the center of a nozzle 21. The plasma torch has a gas piping 23. Further, the chemical supplying means 5 is arranged around the nozzle 21. A chemical is supplied from a chemical port 24. In the plasma torch, when a high voltage is applied to the electrode 22, plasma gas supplied from the gas piping 23 can be changed into plasma, and active atoms activated by the plasma can be discharged from the supply port at the end of the nozzle 21.

In the processing apparatus shown in FIG. 1, the dry processing by the active atoms and the wet processing by the chemical may be provided at the same time. Otherwise, in the processing apparatus shown in FIG. 1, it is possible that the dry processing is provided first, and then the wet processing is provided subsequently. Otherwise, in the processing apparatus shown in FIG. 1, the wet processing is provided first, and then the dry processing is provided subsequently. When the dry processing and the wet processing are provided at the same time, since the workpiece 2 is rotated, the chemical supplied from the chemical supplying means 5 is centrifugalized, and thus lightly covers the whole surface of the workpiece 2 to provide the wet processing. The active atoms supplied from the supply port of the active atom supply means 4 makes part of the thin chemical layer in the vicinity of the supply port evaporate to provide the dry processing for part of the surface of the workpiece 2. By making the supply port of the active atom supply means 4 scan the surface of the workpiece 2, the dry processing can be provided for the whole surface of the workpiece 2.

Further, a description will be given of processing apparatuses of other embodiments with reference to FIG. 6 to FIG. 9B. In FIG. 6 to FIG. 9B, a structure identical with that of FIG. 1 is appended with the identical symbol.

In the processing apparatus shown in FIG. 6, the active atom supplying means 4 and the chemical supplying means 5 shown in the processing apparatus of FIG. 1 are provided separately and movably. As long as the chemical supplying means 5 can supply a chemical for the whole surface of the workpiece, the chemical supplying means 5 may be fixed. For example, when the chemical is supplied in the vicinity of the rotation center of the workpiece, the chemical is centrifugalized and thus supplied for the whole surface of the workpiece.

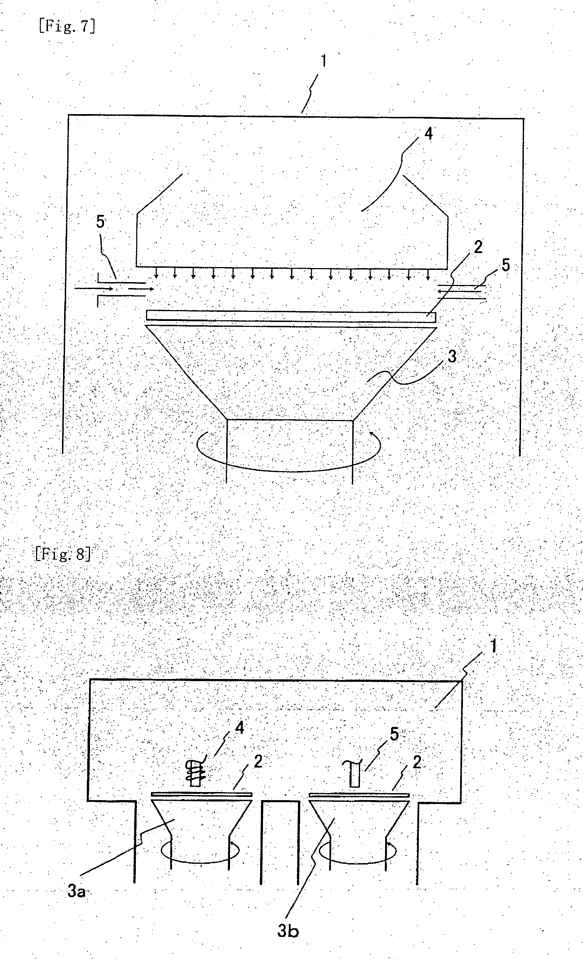

The processing apparatus shown in FIG. 7 is provided with the active atom supplying means 4 with the large area and the chemical supplying means 5 for supplying a chemical through the clearance between the active atom supplying means 4 and the workpiece 2. The active atom supplying means 4 with the large area has a plasma generation source with the large area using, for example, microwave or an electrode. The supply port thereof is opposite to the surface of the workpiece 2, has the area equal to or more than the area of the workpiece 2, and can supply active atoms as a uniform flow. The chemical supplying means 5 is arranged in the direction different from the supply port of the active atom supplying means 4. Since the whole surface of the workpiece 2 can be processed at once by the active atom supplying means 4 with the large area, the lead time can be largely decreased. A plurality of chemical supplying means 5 may be provided to improve the uniformity of wet processing. As the active atom supplying means 4, the supply port may be provided in a state of a line longer than one side of the workpiece 2, and the workpiece 2 may be moved perpendicular to the linear supply port.

The processing apparatus shown in FIG. 8 has a retaining means 3a for retaining the workpiece 2 to be provided with dry processing and a retaining means 3b for retaining the workpiece 2 to be provided with wet processing in the chamber 1. The active atom supplying means 4 is arranged above the retaining means 3a, and the chemical supplying means 5 is arranged above the retaining means 3b. The processing apparatus shown in FIG. 8 may be further provided with a transferring means for transferring the workpiece 2 between the retaining means 3a and the retaining means 3b. In the processing apparatus of FIG. 8, the dry processing and the wet processing can be sequentially performed in the same chamber 1.

The processing apparatus shown in FIGS. 9A and 9B is an aperture capable of processing a plurality of workpieces 2 at the same time by batch method. FIG. 9A is a schematic cross section. FIG. 9B is a schematic plan view. The processing apparatus has a cleaning bath 31 in the chamber 1, the retaining means 3, the active atom supplying means 4 above the cleaning bath 31, a chemical drain pipe 32 below the cleaning bath 31, a diffusion plate 33, and an unshown chemical supplying means.

The cleaning bath 31 pools a chemical supplied from the unshown chemical supplying means, dips the workpiece 2 in the chemical, and thereby performs wet processing. After the wet processing, the chemical is drained from the chemical drain pipe 32. The retaining means 3 retains the plurality of workpieces 2 in an upright posture, so that the plurality of workpieces 2 can be dipped in the chemical of the cleaning bath 31. While the chemical is drained from the chemical drain pipe 32, or after the chemical is drained from the chemical drain pipe 32, active atoms are supplied from the active atom supplying means 4 into the chamber 1. Thereby, processing by the active atoms can be performed for the clean surface of the wet-processed workpiece 2.

The active atom supplying means 4 preferably supplies the active atoms from above to the workpiece 2. In FIGS. 9A and 9B, a torch 34 and a matching box 35 are integrally arranged directly above the cleaning bath 31. As the chemical is drained, the liquid level in the cleaning bath 31 is lowered, and the workpiece 2 is exposed from the upper side thereof. The active atoms supplied from the above proceed downward. While the active atoms collide and are reflected by the liquid level or the bottom face of the cleaning bath, the active atoms are convected. In result, an air current of the active atoms is formed in the cleaning bath. In the course thereof, the active atoms are reacted to the surface of the workpiece 2, and thereby dry processing can be performed uniformly for the whole workpiece. The diffusion plate 33 supports forming the air current by the active atoms.

It is possible that a ventilating means 36 such as a pump is provided for the chemical drain pipe 32. In this case, after the wet processing, the chemical may be drained, and the workpiece may be dried under the reduced pressure. In this case, while vacuum ventilation is performed or after the vacuum ventilation is performed, the vacuum ventilation may be stopped once, and the active atoms such as hydrogen atoms may be supplied from above or from above diagonally. When plasma can be formed at the ambient pressure, plasma can be also generated at the reduced pressure, and thus the active atom supplying means by the foregoing inductively coupled plasma method or the like can be used.

In the apparatus of FIGS. 9A and 9B, by using hydrogen as the active atoms, dangling bond or the like formed on the semiconductor surface can be inactivated by the hydrogen atoms. In result, contamination on the workpiece is decreased, and the surface is inactivated. Thereby, reliability of the semiconductor device can be improved, the manufacturing precision can be further improved, and the manufacturing yield can be improved. In the case of using a marangoni cleaning dry bath, the active atoms are preferably supplied while the workpiece is raised or immediately after the workpiece is raised after cleaning.

As above, the processing apparatus of the invention uses the active atom supplying means capable of supplying active atoms at the ambient pressure. Thereby, the idea that the wet processing is performed in the same chamber as that used in the dry processing is inspired. That is, in the dry processing in which plasma is generated in the vacuum state to supply active atoms, the airtightness and contamination of the chamber itself are problematic, and thus in general, the idea that the wet processing is performed in the same chamber as that used in the dry processing does not come into our heads. The active atom supplying means in the processing apparatus of the invention is not limited to the active atom supplying means capable of supplying the active atoms at the ambient pressure, but preferably can supply the active atoms at the ambient pressure.

Next, a description will be given of processing methods by the processing apparatus of the invention. In a first processing method, a description will be given of a case that the processing method was used for a resist removal step. In the resist removal step, active atoms containing oxygen atoms or hydrogen atoms were used, and a chemical containing heated sulfuric acid was used.

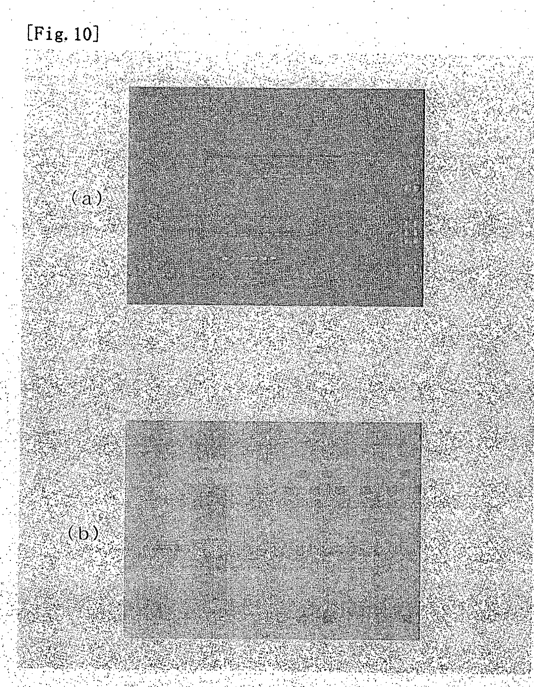

FIG. 10a is an optical microscope photograph of a silicon wafer to which a resist is attached. In the silicon wafer of FIG. 10a, after the 1 µm resist was formed, phosphorous ions (5*10¹⁵ pcs/cm²) were injected therein. The resist surface was heat-hardened. In the past, it had taken about 30 minutes to remove the heat-hardened resist by the existing dry processing.

FIG. 10b is an optical microscope photograph of a silicon wafer after being processed by active oxygen atoms supplied by inductively coupled plasma method. In the inductively coupled plasma method, 100% oxygen gas supplied at the flow rate of 10 L per minute was changed into plasma by applying high frequency of 40 MHz and 900 W to the coil. The distance between the supply port of the active atom supplying means and the wafer was 2 cm, and the irradiation time was 1 second. In FIG. 10b, a silicon pattern was observed, and it was confirmed that the resist was removed.

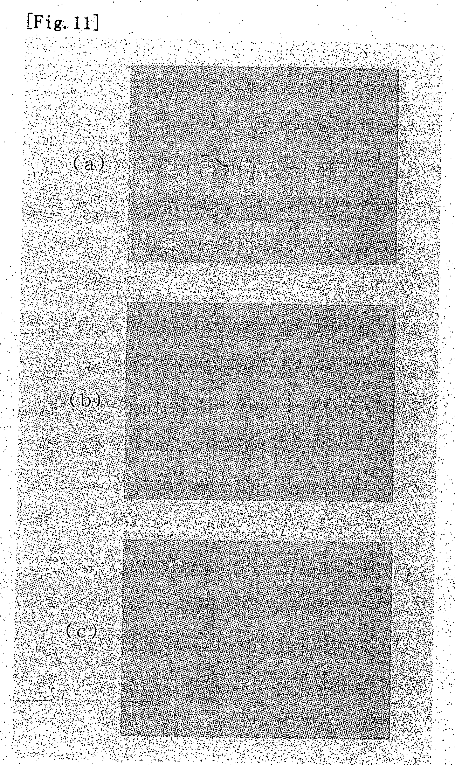

FIGS. 11a, 11b, and 11c are optical microscope photographs of a silicon wafer after being processed by generating active oxygen atoms with the plasma gas type different from each other. In FIG. 11a, when 100% oxygen gas was used on the same condition as in FIG 10b, the resist could be removed by the processing for 1 second. In FIG. 11b, when mixed gas of oxygen gas supplied at the flow rate of 3 L per minute and helium gas supplied at the flow rate of 12 L per minute was used, the resist could be removed by the processing for 5 seconds. In FIG. 11c, when mixed gas of oxygen gas supplied at the flow rate of 3 L per minute and argon gas supplied at the flow rate of 12 L per minute was used, the resist could be removed by the processing for 8 seconds. In all cases, the distance between the supply port of the active atom supplying means and the wafer was 2 cm, and the gas was changed into plasma by applying high frequency of 40 MHz and 900 W to the coil.

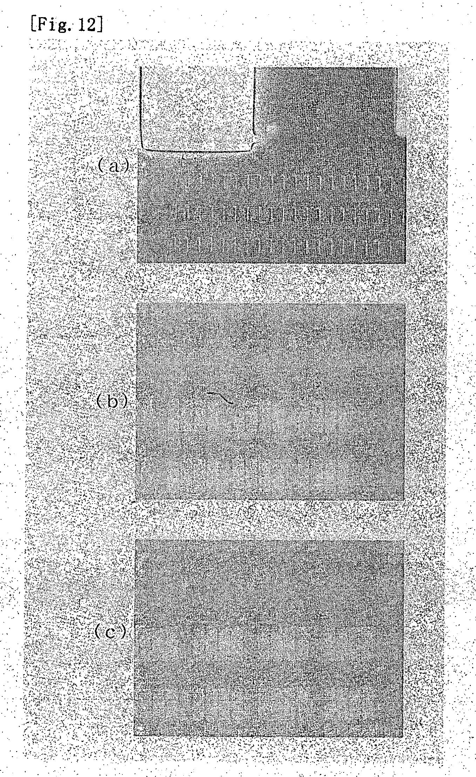

FIGS. 12a, 12b, and 12c are optical microscope photographs of a silicon wafer after being provided with processing. In the processing, in the same manner as in FIG. 11b, mixed gas of oxygen gas supplied at the flow rate of 3 L per minute and helium gas supplied at the flow rate of 12 L per minute was used, and the gas was changed into plasma by applying high frequency of 40 MHz and 900 W to the coil. In FIGS. 12a to 12B, however, the distance between the supply port and the wafer was different from each other. In FIG. 12a, the distance between the supply port and the wafer was 7 cm, and it took 60 seconds until part of the resist surface was removed. In FIG. 12b, the distance between the supply port and the wafer was 5 cm, and it took 15 seconds until the resist surface was sufficiently removed. In FIG. 12c, the distance between the supply port and the wafer was 2 cm, and it took 5 seconds until the resist surface was sufficiently removed. In FIGS. 12a, 12b, and 12c, it was confirmed that there was a tendency that when the distance between the supply port and the wafer was large, the reaction degree of the active atoms was lowered. However, even the distance was large as 7 cm, the sufficient reaction degree was shown. The reason thereof is inferred as follows. That is, by the inductively coupled plasma method at the ambient pressure, high-density plasma was generated.

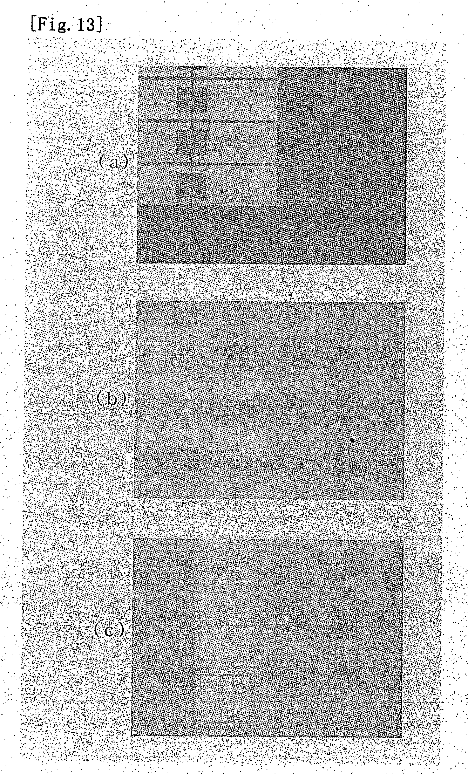

FIGS. 13a, 13b, and 13c are optical microscope photographs of a silicon wafer after being provided with processing. In the processing, mixed gas of hydrogen gas supplied at the flow rate of 2 L per minute and helium gas supplied at the flow rate of 12 L per minute was used. In FIGS. 13a to 13c, the distance between the supply port and the wafer was different from each other. In FIG. 13a, the distance between the supply port and the wafer was 7 cm, and the resist was not able to be removed. In FIG. 13b, the distance between the supply port and the wafer was 5 cm, and it took 30 seconds until the resist surface was sufficiently removed. In FIG. 13c, the distance between the supply port and the wafer was 3 cm, and it took 10 seconds until the resist surface was sufficiently removed. In FIGS. 13a, 13b, and 13c, it was confirmed that though the reaction degree of the active hydrogen atoms was inferior to that of the active oxygen atoms, the active hydrogen atoms could remove the resist as well.

Based on the foregoing experimental results, in the processing apparatus of FIG. 1, dry processing and wet processing were performed at the same time to remove a resist. A wafer was mounted on the retaining means 3 and rotated.
Active atoms containing oxygen atoms or hydrogen atoms were supplied from the supply port (exit of the torch) of the active atom supply means 4, and sulfuric acid at 120 deg C as a chemical was supplied from the chemical supplying means 5. While the wafer was rotated, and while the supply port of the active atom supplying means 4 was moved from the rotation center in the direction of the radius of the wafer by steady accelerated motion, the active atoms were supplied. Thereby, the active atoms could be supplied for the whole face of the workpiece 2. As the location is apart from the vicinity of the rotation center in the direction of the radius, the linear velocity of the wafer becomes faster. Therefore, it is preferable that the movement velocity of the supply port of the active atom supply means 4 is slowed, so that the active atoms can be supplied uniformly for the whole surface of the wafer. As described above, the heat-hardened surface section of the resist could be immediately removed by the dry processing using the active atoms, and the remaining section of the resist could be removed by wet processing using sulfuric acid. In result, it could be confirmed that the resist was removed by dry cleaning by the active oxygen atoms and wet cleaning by sulfuric acid, and the surface was cleaned. In the existing SPM, hydrogen peroxide was mixed in sulfuric acid. Meanwhile, in the invention, the active oxygen atoms functioned as an oxidizing reagent. Therefore, even with no hydrogen peroxide mixed therein, sufficient cleaning effects could be obtained.

As described above, the dry cleaning and the wet cleaning that had been performed separately in different apparatuses in the past could be cleaned in the same apparatus at the same time. Therefore, the lead time could be shortened. Further, contamination attached to the wafer while the wafer was transferred between apparatuses could be prevented, and thus contamination on the wafer was decreased, and the reliability of the semiconductor integrated circuit device could be improved. In addition, when the high-density active atoms supplied by inductively coupled plasma method at the ambient pressure were used, time necessary to remove the resist could be largely shortened, and the lead time could be shortened.

Further, after the resist was removed by the dry processing using the active atoms containing oxygen atoms or hydrogen atoms, finishing etching could be performed by the wet processing using sulfuric acid. Further, when the processing apparatus of FIG. 2 was used, the resist could be also removed by performing the dry processing and the wet processing at the same time or sequentially.

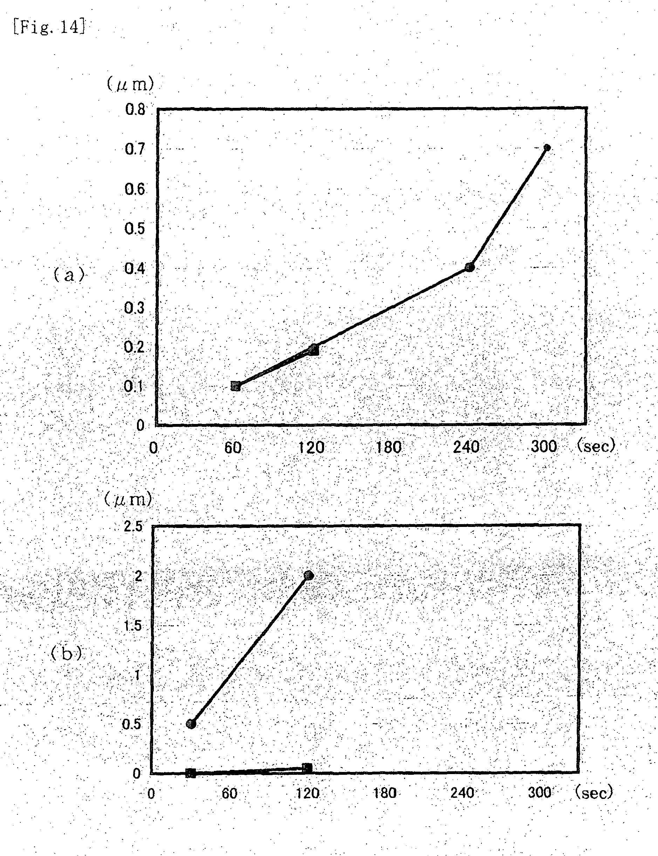

In FIGS. 14a and 14b, the horizontal axis represents the processing time (second), and the vertical axis represents the etching film thickness (µm). In the figures, graphs with black circles represent results of processing an ordinary resist film. In the figures , graphs with black squares represent results of processing a heat-hardened resist film by ion implantation. FIG. 14a shows a case using active hydrogen atoms, and FIG. 14b shows a case using active oxygen atoms.

FIG. 14a shows the etching amount per unit time, that is, the etching velocity on condition that mixed gas of hydrogen gas supplied at the flow rate of 1 L per minute and helium gas supplied at the flow rate of 15 L per minute was used, and the distance between the supply port of the active atom supplying means and the wafer was 8 cm. In FIG. 14a, it was confirmed that when the active hydrogen atoms were used, both in the case of the ordinary resist film (graph with black circles in the figure) and in the case of the hardened resist film (graph with black squares in the figure), etching could be performed at an etching rate of about 0.1 µm/60 seconds.

FIG. 14b shows the etching velocity on condition that oxygen gas supplied at the flow rate of 6 L per minute was used, and the distance between the supply port of the active atom supplying means and the wafer was 6 cm. In FIG. 14b, it was confirmed that when the active oxygen atoms were used, in the case of the ordinary resist film (graph with black circles in the figure), etching could be performed at the etching velocity of about 0.1 µm/60 seconds, while in the case of the hardened resist film (graph with black squares in the figure), the etching velocity was about 0.02 to 0.03 µm/60 seconds.

The results of FIGS 14a and 14b show the followings. That is, in the case of using the active hydrogen atoms, the etching velocity was almost the same for both the ordinary resist film and the hardened resist film, showing no selectivity according to the difference of the resist film type. Meanwhile, in the case of using the active oxygen atoms, the etching velocity of the ordinary resist film was larger than that of the hardened resist film, showing selectivity according to the difference of the resist film type. Therefore, when the resist film with the surface hardened is etched by the active oxygen atoms having selectivity, there is a possibility that an ordinary resist as a foundation is removed by the active oxygen atoms intruding therein before the resist with the surface hardened is removed. In result, the hardened resist may remain to become particles. It is needless to say that the particles can be removed by wet processing. However, when the resist is removed by the active hydrogen atoms having no selectivity, the particles resulting from remaining hardened resist is decreased.

Further, though the etching velocity in the case of using the active oxygen atoms was larger than that in the case of using the active hydrogen atoms for the ordinary resist film, the etching velocity in the case of using the active hydrogen atoms was larger than that in the case of using the active oxygen atoms for the hardened resist film. Therefore, when the dry processing is performed for the purpose of removing the hardened resist film, the active hydrogen atoms are preferably used. For example, the resist film with the surface hardened may be etched by dry processing with the use of the active hydrogen atoms, and the ordinary resist thereunder may be etched by dry processing with the use of the active oxygen atoms or wet processing by a chemical. As explained with reference to FIGS. 12a to 12c, the etching velocity itself can be changed by changing the distance from the supply port of the active atom supplying means and the wafer. Therefore, the hardened resist can be removed faster even by the dry processing with the use of the active oxygen atoms, and the resist can be removed faster by the dry processing with the use of the active hydrogen atoms.

As a second processing method, the processing method of the invention was used for a cleaning step. In this case, instead of using APM, HPM, SPM, FPM, or DHF in the existing cleaning step as before, active atoms containing oxygen atoms were used, and a chemical containing ammonium hydroxide, hydrochloric acid, or hydrofluoric acid was used. In this case, the active oxygen atoms function as an oxidant, and cleaning effects by an acid or an alkali can be improved. Further, by controlling the flow rate of gas, the supply amount of the active oxygen atoms can be controlled. In result, high-precision cleaning effects can be obtained.

For example, 2-phase cleaning steps were performed by using the retaining means 3 as shown in FIG. 2. First, in the first workpiece position 3a, the active oxygen atoms were supplied from the active atom supplying means 4 to the workpiece 2, and an ammonium hydroxide aqueous solution was supplied from the chemical supplying means 5 to the workpiece 2. Thereby, the surface of the workpiece 2 was oxidized by the active oxygen atoms, the resultant oxidized film was removed by the ammonium hydroxide aqueous solution, and thereby particles on the surface were removed. After that, the whole retaining means 3 was rotated 180 degree. Then, in the second workpiece position 3b, the active oxygen atoms were supplied from the active atom supplying means 4 to the workpiece 2, and hydrofluoric acid was supplied from the chemical supplying means 5 to the workpiece 2. Thereby, the surface of the workpiece 2 was oxidized by the active oxygen atoms, the resultant oxidized film was removed by the hydrofluoric acid, and thereby contamination on the surface could be removed.

As a third processing method, when a semiconductor substrate was used as a workpiece and active atoms containing hydrogen atoms were used, atoms on the surface of the semiconductor were bonded with the hydrogen atoms, and a stable interface state could be obtained. For example, when the active atoms containing hydrogen atoms were supplied to silicon, a natural oxidized film formed on the surface of silicon could be deoxidized by the active hydrogen atoms. When ultra pure water was used as a chemical, the silicon surface was exposed due to washout action by the ultra pure water. On the surface on which the natural oxidized film was deoxidized by the hydrogen atoms, excessive hydrogen atoms were bonded with the silicon surface, the silicon surface was covered with the hydrogen atoms, and thereby the surface was inactivated. In result, after cleaning, a high quality silicon surface covered with extremely high-precision hydrogen atoms could be realized. Further, after the oxidized film on the silicon surface was removed by hydrofluoric acid or the like, the active hydrogen atoms could be bonded with the exposed silicon surface, and thereby a high quality silicon surface could be obtained. That is, in this case, processing was made by using the active atoms containing hydrogen atoms and a chemical containing hydrofluoric acid.

Further, it is also possible to process a plurality of workpieces with batch method by using the processing apparatus shown in FIGS. 9A and 9B. For example, DHF is filled in the cleaning bath 31 of FIGS. 9A and 9B. The retaining means 3 retaining the plurality of workpieces 2 was dipped into DHF to perform wet processing. After that, while DHF is suctioned and drained through the chemical drain pipe 32 by the ventilating means 34, the active atoms containing hydrogen atoms are supplied from the active atom supplying means 4 into the chamber 1. The active hydrogen atoms are supplied to the surface of the workpiece 2 exposed by lowering the liquid level of the cleaning bath 31, and thereby the surface can be inactivated.

A description will be given of a fourth processing method. When an HF/HNO₃ (1/20) mixture is used as a chemical for silicon, the silicon surface is oxidized by HNO₃, and the oxidized film is etched by HF. Thereby, isotropic wet etching processing can be performed. However, though HNO₃ is a strong oxidant, it is difficult to handle HNO₃ as a chemical. Therefore, In this fourth processing method, instead of HNO₃, active oxygen atoms were supplied and HF was supplied as a chemical. In result, the oxygen atoms operated as an oxidant, and thereby silicon etching processing could be performed.

Further, in anisotropic wet etching processing using a hydrazine aqueous solution or a potassium hydroxide aqueous solution as a chemical, oxygen atoms as an oxidant were supplied as active atoms. In result, etching could be inhibited.

As a fifth processing method, the method can be applied to a process for removing a silicon nitride film. First, by using the retaining means 3 shown in FIG. 3, in the first workpiece position 3a, a hydrofluoric acid aqueous solution as a chemical was supplied to a workpiece, and an oxidized film on the silicon nitride film was removed to perform wet cleaning step. Next, by revolving the retaining means 3, the workpiece was moved to the second workpiece position 3b. Plasma was generated from plasma gas containing CF₄/CHF₃ gas, active atoms containing fluorine atoms and hydrogen atoms were supplied, a chemical containing heated phosphoric acid was supplied, and thereby the silicon nitride film was removed. The etching selection ratio between the silicon nitride film and the oxidized film was 20:1. After the processing, the retaining means 3 was revolved to move the workpiece to the third workpiece position 3c. The hydrofluoric acid aqueous solution as a chemical was supplied, and hydrogen atoms as active atoms were supplied. Thereby, an oxidized film as a foundation of the silicon nitride film could be removed, and at the same time the silicon surface could be covered with the hydrogen atoms originated from the active hydrogen atoms.

In the past, time necessary for manufacturing a semiconductor integrated circuit device had been 4 hours (in units of 25 pieces). Meanwhile, in this method, such time could be shortened down to 1 hour (in units of 25 pieces). Further, by covering the silicon surface after finishing the step with the hydrogen atoms, the reliability of the semiconductor integrated circuit device could be improved.

As described above, by supplying the oxygen atoms in the steps of the semiconductor wafer cleaning and the surface processing, the acid oxidant can be used as a substitute, and the chemical usage amount can be decreased. Further, the strong oxidant hard to handle due to its hazardous characteristics can be substituted with the oxygen atoms. Furthermore, when the hydrogen atoms are supplied to the oxidant, both cleaning effect by the chemical and surface stability are promoted. Such dry/wet mix cleaning gives a new cleaning function, and largely increases the freedom degree of the cleaning method, compared to the cleaning step with the use of only the chemical.

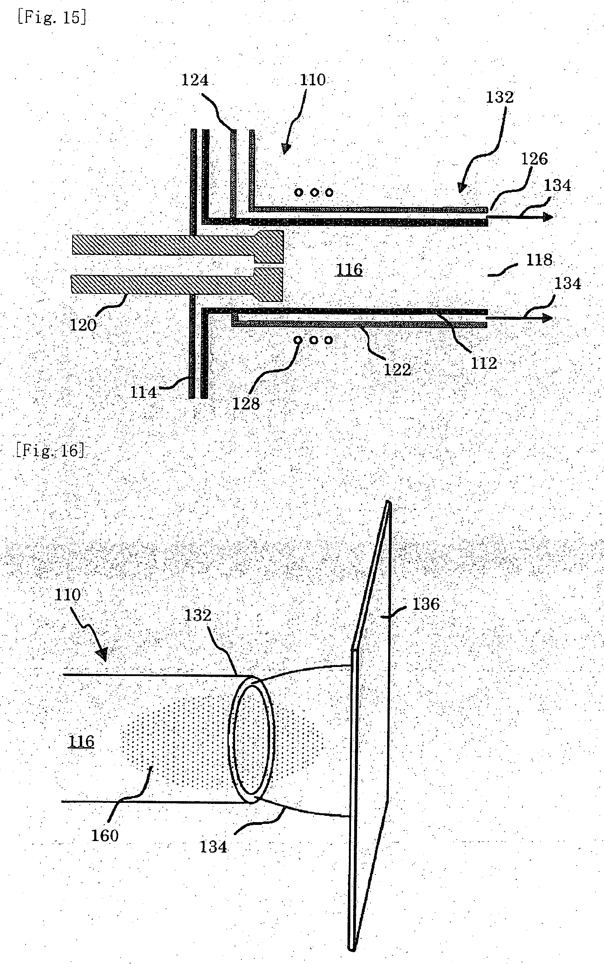

Next, a description will be given of a plasma source in which at least part of plasma is covered with a liquid curtain, with reference to FIG. 15 to FIG. 21. In the active atom supplying means 4 and the chemical supplying means 5 shown in FIGS. 1, 4, and 5, the chemical eruption port of the chemical supplying means 5 is arranged around the aperture of the active atom supplying means 4. In this case, the plasma source in which at least part of plasma is covered with a liquid curtain is obtained.

### Plasma source

The plasma source is intended to change gas such as argon and helium into plasma in a plasma generating section. The plasma source is used for analyzing a sample workpiece transferred into the plasma, processing the surface of a workpiece such as a semiconductor wafer, decomposition processing of a workpiece such as PCP and CFC or the like. The plasma source may have any structure, as long as the plasma source can generate usable plasma. For example, as shown in FIG. 15, a plasma source 110 is in the shape of a torch. The plasma source 110 includes a carrier gas tube body 120, a plasma gas tube body 112, and a liquid-use tube body 122. A plasma source 110 has a plasma generating section 116 inside the plasma gas tube body 112. The carrier gas tube body 120 transfers an analysis-use sample, a materiel for surface processing or the like, and a sample such as a processing material into the plasma. As carrier gas for transferring the foregoing samples, the same gas as plasma gas or gas different from the plasma gas can be used. Otherwise, it is possible that the carrier gas is not used, and a material in a state of liquid, mist, or gas is transferred into the plasma. In the case of a liquid material, such a liquid material may be transferred in a state of aerosol obtained by an atomizer, or the liquid material may be previously vaporized and transferred, or the liquid material itself may be directly transferred. The plasma source 110 can generate plasma usable at a pressure from a low pressure to a high pressure that is the atmospheric pressure or more. As described above, in the invention, plasma includes both a state that most atoms are ionized and a state that most atoms are neutral particles and partial atoms are ionized. Further, the carrier gas tube body 120, the plasma gas tube body 112, and the liquid-use tube body 122 can be made of a material such as quartz glass and ceramics. As the plasma gas and the carrier gas, in addition to noble gas such as argon and helium, various gas such as oxygen, hydrogen, nitrogen, methane, CFC, air, and water vapor or a mixture thereof can be used.

### Plasma gas tube body

The plasma gas tube body 112 is arranged, for example, around the outer circumference of the carrier gas tube body 120, and forms the plasma generating section 116 in part. When the plasma gas tube body 112 is in the shape of a cylinder, the plasma gas tube body 112 is arranged concentrically in relation to the carrier gas tube body 120. The plasma gas tube body 112 transfers plasma gas to the plasma generating section 116. The plasma gas is preferably transferred so that the plasma gas is rotated along the cylindrical internal wall face in the plasma generating section 116. To that end, as shown in FIG. 15, a plasma gas lead pipe 114 for leading the plasma gas is arranged in the direction tangent to the circle circumference of the plasma gas tube body 112. To increase the flow velocity of the plasma gas in the lead section of the plasma generating section 116, a clearance between the carrier gas tube body 120 and the plasma gas tube body 112 is narrowed. To that end, the section of the carrier gas tube body 120 on the plasma generating section 116 side may have a large diameter.
Otherwise, though not shown, the outer circumference of the carrier gas tube body 112 may have a large diameter as a whole. The plasma gas tube body 112 includes an aperture 118. The aperture 118 is provided at an end of the plasma generating section 116. Plasma is sent from the aperture 118 toward outside of the plasma generating section 116.

### Plasma generating section

The plasma generating section 116 is formed, for example, inside the plasma gas tube body 112. One end of the plasma generating section 116 is an end of the carrier gas tube body 120, and the other end of the plasma generating section 116 is the aperture 118 of the carrier gas tube body 120. Plasma is discharged forward from the aperture 118. When the plasma gas tube body 112 is cooled by a liquid, the plasma gas tube body 112 can be prevented from being diffused, and thereby the plasma generating section 116 can be long. Thereby, the sampling depth can be formed long, and the analysis sensitivity can be improved. Further, in the mass analysis, effects of secondary discharge as a cause of lowering the analysis sensitivity can be reduced. In this embodiment, the plasma generating section 116 represents a plasma generating cell inside the plasma gas tube body 112. However, the plasma generating section 116 is not limited to the cell, but may be any space as long as the plasma can be generated therefrom. In that case, the aperture 118 is the location from which the generated plasma is firstly moved.

### Liquid-use tube body

The liquid-use tube body 122 supplies, for example, a liquid to the surrounding area of the plasma gas tube body 112. The liquid-use tube body 122 is arranged around the outer circumference of the plasma gas tube body 112. When the liquid-use tube body 122 is in the shape of a cylinder, the liquid-use tube body 122 is arranged concentrically in relation to the plasma gas tube body 112. The liquid is injected from a liquid lead pipe 124, is flown through the space between the liquid-use tube body 122 and the plasma gas tube body 112, and can cool the plasma gas tube body 112. The liquid-use tube body 122 is arranged to cover the plasma gas tube body 112. The liquid is preferably transferred so that the liquid is rotated around the outer circumference of the plasma gas tube body 112. To that end, as shown in FIG. 15, the liquid lead pipe 124 is arranged in the direction tangent to the circle circumference of the liquid-use tube body 122. In FIG. 15, the liquid lead pipe 124 extends from the liquid-use tube body 122 in the same direction as that of the plasma gas lead pipe 114 (upward direction in FIG. 15), but preferably extends in the direction different from that of the plasma gas lead pipe 114. That is, it is preferable that the liquid lead pipe 124 and the plasma gas lead pipe 114 are provided with an appropriate angle in relation to the axis of the housing. Thereby, the liquid lead pipe 124 and the plasma gas lead pipe 114 are not close to each other, and piping connection becomes easier. The type of liquid may be any type, as long as the liquid can effectively cool the plasma gas tube body 112, and does not disturb the plasma stability. As a liquid that can be handled easily and inexpensive, water is suitable. Further, as a liquid, a cleaning-use chemical can be also used. As the cleaning-use chemical means a chemical or an aqueous solution of an acid, an alkali, an alcohol, or CFC. Otherwise, according to needs, a vapor-liquid 2 phase mixture of gas and a liquid may be used.

### Liquid supplying section

A liquid supplying section 132 forms a liquid curtain 134 as a liquid film. The liquid curtain 134 covers the plasma formed in the plasma generating section 116. The liquid curtain 134 can be a kind of chamber. The plasma can be formed in the liquid curtain 134 as well. The liquid supplying section 132 can use, for example, the liquid-use tube body 122. The liquid supplying section 132 has a discharge port 126 at an end of the liquid-use tube body 122, that is, in the vicinity of the aperture 118 of the plasma generating section 116. The discharge port 126 has a structure that the liquid can be erupted forward from the liquid-use tube body 122. The liquid is preferably discharged from the discharge port 126 while rotating around the axis of the aperture 118. It is enough that the liquid supplying section 132 is structured to cover the plasma with the liquid curtain 134. Therefore, it is possible that the liquid-use tube body 122 is not used. For example, when the liquid supplying section 132 forms the liquid curtain 134 around the plasma, unnecessary gas can be prevented from being mixed into the plasma, and lowering of the plasma purity can be prevented. "Covering the plasma" includes both covering the entire surrounding area of the plasma, and covering part of the surrounding area of the plasma. By covering the plasma as above, outside unnecessary gas can be prevented from intruding into the plasma, and the mixture ratio of the unnecessary gas can be lowered. Further, the liquid curtain 134 includes, in some cases, a curtain formed from a fog/mist film. Thereby, the mixture ratio of the unnecessary gas can be lowered.

FIG. 16 shows part of the plasma source 110 in which an opposing member 136 is arranged opposite to the plasma generating section 116. Plasma 160 partly exists outside in front of the plasma generating section 116. The liquid supplying section 132 erupts the liquid toward the opposing member 136. The liquid supplying section 132 erupts the liquid from around the aperture 118 of the plasma generating section 116 to form the liquid curtain 134 around the plasma 160. By the liquid curtain 134 and the opposing member 136, the plasma 160 can be blocked from outside air, and unnecessary gas can be prevented from being mixed in the plasma 160. When 2 or more chemicals are used, the liquid supplying section 132 may have 2 layer structure. In this case, 2 or more liquid lead pipes 124 may exist. Further, in the liquid supplying section, 2 or more chemicals may be mixed.

### Shape of the aperture of the plasma gas tube body and shape of the discharge port of the liquid-use tube body

The shape of the discharge port 126 plays an important role for the shape of the liquid curtain 134 and the stability of the plasma 160. The end of the plasma gas tube body 112 and the end of the liquid-use tube body 122 of FIG. 15 are cut in the same position of the central axis. Thereby, the liquid is discharged outside in the direction of the axis. When the liquid is rotated along the internal circumference of the liquid-use tube body 122, the shape of the liquid curtain 134 is determined by the centrifugal force due to the rotation centering on the central axis of the tube body, the surface tension of the liquid, the pressure of the plasma gas, and the power balance such as the outside pressure. The shape of the liquid curtain 134 can be obtained by the type, the flow rate, the flow velocity, and the rotation velocity of the liquid in the liquid-use tube body 122 and the shape of the discharge port.

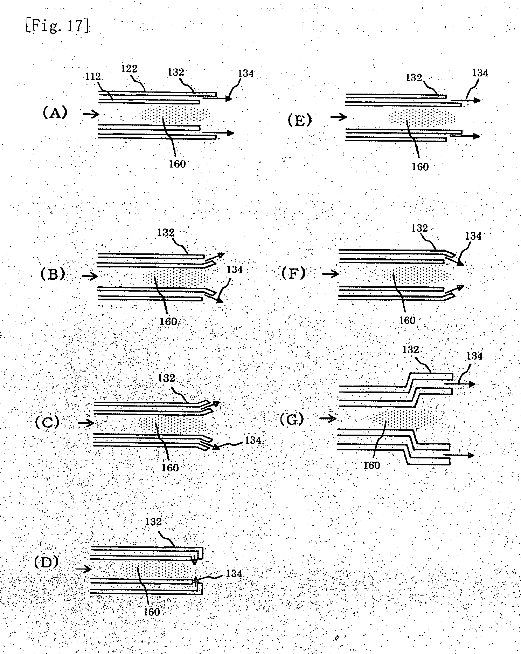

The shape of the end of the plasma gas tube body 112 and the shape of the end of the liquid-use tube body 122 can vary according to needs. FIGS. 17A to 17G show structures of the end of the liquid supplying section 132 of the plasma torch. The end of the liquid supplying section 132 is composed of the end the plasma gas tube body 112 and the end of the liquid-use tube body 122. For example, as shown in FIG. 17A, the end of the liquid supplying section 132 can be formed so that the end of the liquid-use tube body 122 protrudes from the end the plasma gas tube body 112. By such a structure, the liquid curtain 134 is formed along the axis direction.
Otherwise, as shown in FIG. 17B, the end of the liquid supplying section 132 can be formed so that the end the plasma gas tube body 112 protrudes from the end of the liquid-use tube body 122, and is bent being slanted in the direction of the outer circumference. Otherwise, as shown in FIG. 17C, the end of the liquid supplying section 132 can be formed so that both the end of the liquid-use tube body 122 and the end the plasma gas tube body 112 are bent being slanted in the direction of the outer circumference. Otherwise, as shown in FIG. 17D, the end of the liquid supplying section 132 can be formed so that the end of the liquid-use tube body 122 protrudes from the end the plasma gas tube body 112, and is bent at right angles in the direction of the inner circumference. Otherwise, as shown in FIG. 17E, the end of the liquid supplying section 132 can be formed so that the end the plasma gas tube body 112 protrudes from the end of the liquid-use tube body 122. Otherwise, as shown in FIG. 17F, the end of the liquid supplying section 132 can be formed so that the end of the liquid-use tube body 122 protrudes from the end the plasma gas tube body 112, and the end of the liquid-use tube body 122 is bent being slanted in the direction of the inner circumference. Otherwise, as shown in FIG. 17G, the end of the liquid supplying section 132 can be formed so that both the end of the liquid-use tube body 122 and the end the plasma gas tube body 112 are bent being slanted in the direction of the outer circumference, and the end of the liquid-use tube body 122 and the end the plasma gas tube body 112 protrude in parallel with the axis. In FIGS. 17B to 17D, 17F, and 17G, the deformed end of the plasma gas tube body 112 can be regarded as eaves. The eaves of FIG. 17B are in the shape of a funnel spreading from the end of the tube body to outside. The spreading angle is determined so that the liquid is set apart from the plasma without disturbing the stability of the plasma. By forming the shape of the plasma gas tube body 112 and the shape of the end of the liquid-use tube body 122 in various ways as described above, the shape of the liquid curtain 134 can be formed in a given shape.

### Plasma generating apparatus

A plasma generating apparatus 128 changes plasma gas into a plasma state. In the plasma generating apparatus 128, for example, a lead coil as a loading coil is wound around the outer circumference of the liquid-use tube body 122, a high frequency oscillator is connected to the lead coil, and high frequency is applied to the lead coil. The plasma generating apparatus 128 can use not only inductively coupled plasma method, but also various methods such as microwave plasma method using a cavity resonator and electrode method such as parallel flat plates and coaxial type. The electric power for generating plasma can be applied in various modes from direct current, alternate current, high frequency, to microwave or more. Further, plasma may be generated by introducing light such as laser from outside of the plasma generating section. Further, plasma may be generated by combusting combustible gas, combustible liquid, combustible solid or the like. Further, plasma may be generated by combining the foregoing methods.

### Structures of various plasma sources

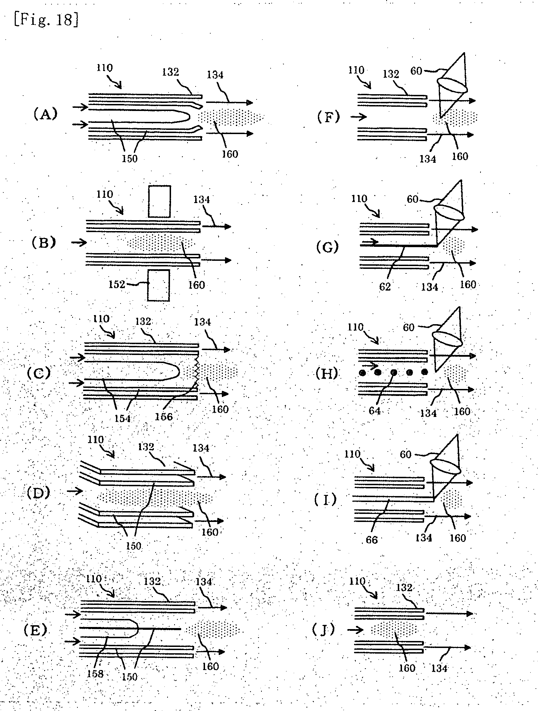

FIG. 18A to FIG. 19D show structures of the various plasma sources 110. In FIG. 18A, plasma gas is flown from the left direction to the plasma generating section, a voltage is applied between electrodes 150, 150, and thereby the plasma 160 is formed. The liquid curtain 134 is formed in the liquid supplying section 132. The plasma 160 becomes plasma jet, and is flown in the liquid curtain 134 in the right direction. In the right direction, the plasma 160 has many neutron particles, and less ionized particles. In FIG. 18B, plasma gas is flown from the left direction to the plasma generating section, and the plasma 160 is formed by cavity resonators 152, 152. The plasma 160 is microwave plasma, and is flown down stream in the right direction. In FIG. 18C, plasma gas is flown from the left direction to the plasma generating section, and the plasma 160 is formed by co-axial electrodes 154, 154. An electrode in a state of web or mesh is arranged in the vicinity of the aperture 118 of the plasma generating cell 116. The plasma 160 is co-axial plasma, and is flown down stream in the right direction. In FIG. 18D, plasma gas is flown from the left direction to the plasma generating section, and the plasma 160 is formed by parallel flat plate electrodes 150, 150. The plasma 160 is parallel flat plate plasma. In FIG. 18E, plasma gas is flown from the left direction to the plasma generating section, and the plasma 160 is formed by a plasma needle electrode 150 and a cylindrical electrode 150. The needle electrode 150 is fixed inside an insulating body 158. In FIG. 18F, plasma gas is flown from the left direction to the plasma generating section, and the plasma 160 is formed by laser 60. In FIG. 18G, a continuous liquid target 62 as a continuous liquid beam is flown from the left direction to the plasma generating section, and the plasma 160 is formed by laser 60. In FIG. 18H, an intermittent liquid target 64 as intermittent liquid particles is intermittently flown from the left direction to the plasma generating section, and the plasma 160 is formed by laser 60. In FIG. 18I, a solid target 66 is supplied from the left direction, and the plasma 160 is formed in the plasma generating section by laser 60. In FIG. 18J, a fuel is supplied from the left direction, and a combustible plasma 162 is formed by flame. Sample gas or sample mist may be flown from the left direction to the plasma generating section. As gas, in addition to the combustible gas, combustible liquid such as gasoline or a solid may be erupted or sprayed to be combusted.

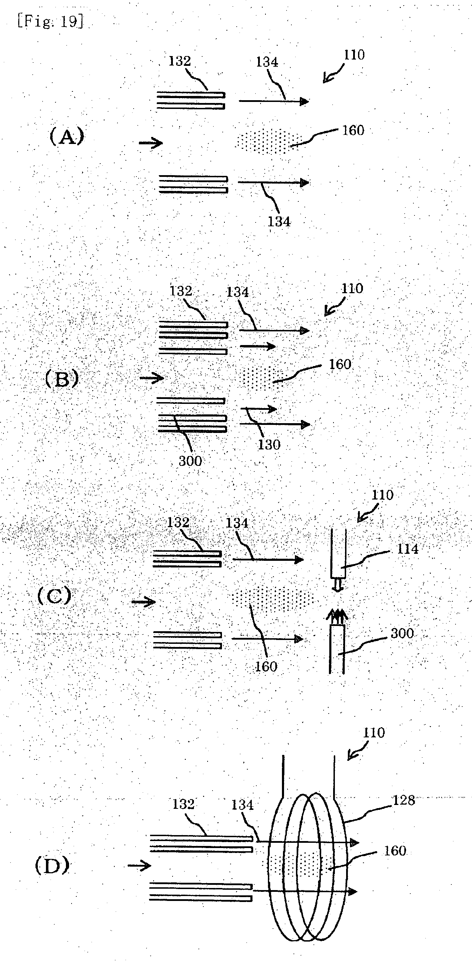

FIG. 19A shows the plasma source 110 in which the liquid curtain 134 is formed far apart from the plasma 160. It is possible that the liquid curtain 134 is not integrated with the plasma 160, and is formed to widely surround around the plasma generating apparatus 128. In FIG. 19B, other gas, liquid, or liquid mist 130 is flown by a gas/mist gas supplying section 300 into the space between the liquid curtain 134 and the plasma 160. In FIG. 19C, gas, mist, liquid, other plasma or the like is supplied by the plasma gas lead pipe 114 of another nozzle or the gas/mist gas supplying section 300. In FIG. 19D, the liquid curtain 134 is used a kind of chamber. Inside the liquid curtain 134, the plasma 160 is formed by the coil of the plasma generating apparatus 128.

### Examples of the liquid curtain

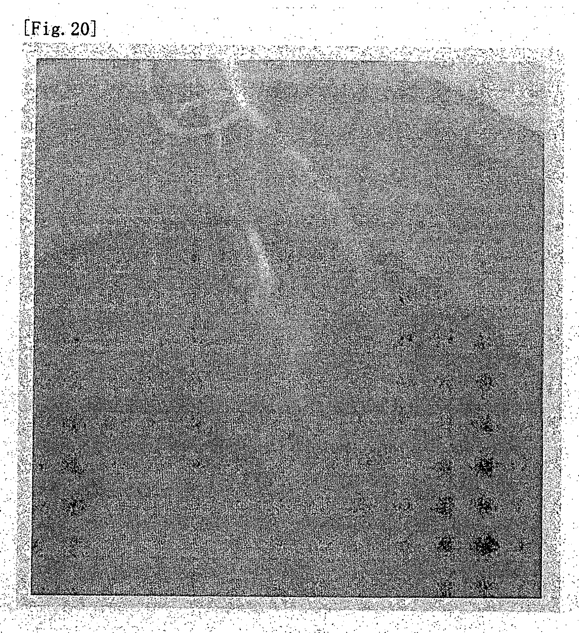

FIG. 20 shows an example for forming the liquid curtain 134 by erupting water from the discharge port 126 of the liquid-use tube body 122 toward the bottom of a tub. The liquid curtain 134 erupted from the liquid-use tube body 122 reaches the water surface over the bottom of the tub. In the example shown in FIG. 20, gas is not introduced from the plasma generating section 116. The liquid curtain 134 is once spread in the vicinity of the discharge port 126, and again is unspread.
Water is rotated along the inner circumference of the liquid-use tube body 122. The water erupted from the discharge port 126 is spread in the direction of the outer circumference due to rotation centrifugal force. After that, the water is unspread in the direction of the inner circumference due to the surface tension of the water. In this case, the flow rate of the water is 3.3 L/minute. The inner diameter of the liquid-use tube body 122 is 18 mm. The outer diameter of the plasma gas tube body 112 is 16 mm. Therefore, the thickness of the flow channel of the liquid is expressed as (18 mm-16 mm)/2=1 mm.

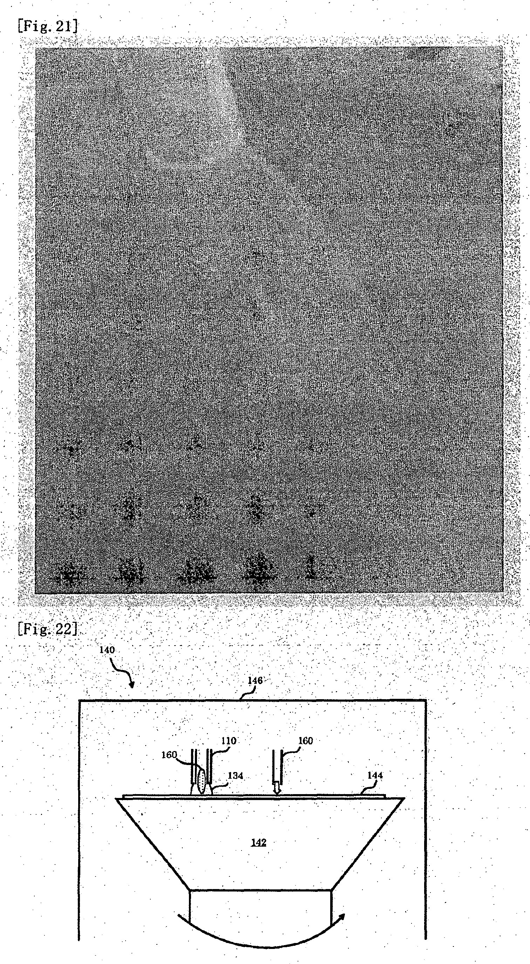

FIG. 21 shows an example in which the liquid curtain 134 is formed by erupting water from the discharge port 126 of the liquid-use tube body 122 in the same manner as in FIG. 20, while plasma or gas is introduced from the plasma generating section 116 to the inner side of the liquid curtain 134. The liquid curtain 134 of FIG. 21 forms a shape with the end spread in a state of a hanging bell, and reaches the water surface over the bottom of a tub. When the liquid curtain 134 of FIG. 21 is once spread in the direction of the outer circumference, the liquid curtain 134 retains the shape spread in the state of a hanging bell even when gas supply is stopped. Such a phenomenon is regarded as the phenomenon showing that the gas is enclosed by the liquid curtain 134 and the water surface of the tub.

In the example of FIG. 21, when the distance between the discharge port 126 of the liquid-use tube body 122 and the water surface of the tub is about 20 cm or more, the hanging bell is broken and the liquid curtain 134 returns to the shape of the example of FIG. 20. Therefore, when the liquid-use tube body 122 is used and water is used as the liquid curtain 134, in the case that the distance between the discharge port 126 of the liquid-use tube body 122 and the water surface of the tub is about 20 cm at the maximum, outside gas can be prevented from being mixed in the plasma 160. In this case, as in the example of FIG. 20, the flow rate of the water is 3.3 L/minute. The inner diameter of the liquid-use tube body 122 is 18 mm. The outer diameter of the plasma gas tube body 112 is 16 mm. Therefore, the thickness of the flow channel of the liquid is expressed as (18 mm-16 mm)/2=1 mm.

A description will be given of a usage example of the plasma source including the liquid curtain.

### Processing apparatus

FIG. 22 shows a processing apparatus 140 using the plasma source 110. The processing apparatus 140 processes a workpiece 144 such as a silicon wafer. The processing apparatus 140 includes a chamber 146, the plasma source 110 in the chamber 146, and a retaining section 142 for retaining the workpiece 144 in the chamber 146. The plasma source 110 transfers the plasma 160 from the plasma generating section 116 forward outside. The outside plasma 160 is covered with the liquid curtain 134. The plasma 160 performs surface processing such as removing a resist of the workpiece 144. According to the workpiece 144 and the processing, the type of plasma gas is determined. Further, when the workpiece 144 is wet-processed, a liquid to be used is a chemical for processing, and the type of chemical is determined according to the processing. The chemical may be injected into the workpiece 144 by an independent chemical injection apparatus 148 instead of the liquid supplying section 132. When such an independent chemical injection apparatus 148 is used as above, the freedom degree of processing steps is increased. In result, dry processing by the plasma 160 and wet processing by the chemical can be performed at once, concurrently, or sequentially.

The retaining section 142 retains the workpiece 144, and if necessary, makes the workpiece 144 rotate centering on the rotation axis of the workpiece 144. The plasma source 110 is arranged opposite to the workpiece 144, and can perform estrangement movement and approach movement relatively to the workpiece 144. Further, the plasma source 110 maintains a constant clearance in relation to the workpiece 144, and can perform parallel movement relatively. By such a movement, plasma processing can be performed for even a large workpiece 144, and chemical processing can be also performed.

### Processing method

When the plasma source 110 is used in a processing method, various processing becomes enabled. For example, the plasma source 110 can use any of plasma, gas, liquid, and mist. Further, the plasma source 110 can use interaction between or among 2 or more of the foregoing. Furthermore, the plasma source 110 can use plasma, gas, liquid, and mist at the same time or alternately. In the plasma source 110, it is possible that only the liquid curtain 134 is formed in a state that the plasma 160 is not lit, and other gas or mist is introduced in the liquid curtain 134. Otherwise, a sample can be cooled in the liquid curtain 134.

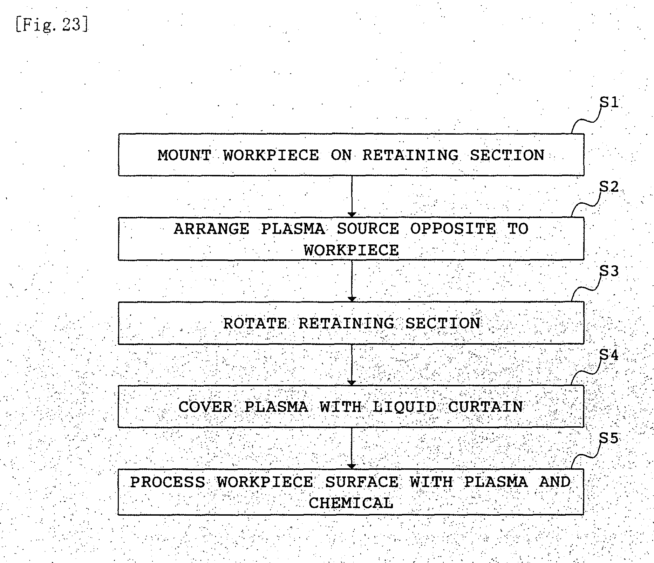

FIG. 23 shows a processing method of the workpiece 144. First, the plasma source 110 and the retaining section 142 are arranged in the chamber 146. Next, the workpiece 144 is mounted on the retaining section 142, and fixed (S1). The plasma source 110 is arranged opposite to the workpiece 144 (S2). The retaining section 142 is rotated (S3). The plasma 160 is covered with the liquid curtain 134 (S4). Thereby, unnecessary gas such as outside air can be prevented from being mixed in the plasma 160. With the use of the plasma 160 and the chemical, surface processing is performed for the workpiece 144 (S5). In the surface processing, dry processing by the plasma 160 and wet processing by the chemical can be performed at once, concurrently, or sequentially.

### Mass analysis

Mass analysis is performed, for example, by using an unshown sampler and an unshown mass spectroscope. The mass analysis is performed by transferring a sample workpiece to be analyzed with carrier gas to the plasma generating section 116. Then, plasma gas is introduced to the plasma generating section 116, while being rotated inside the plasma gas tube body 112 through the lead pipe 114. Part of the plasma gas is changed into plasma by the plasma generating apparatus in the plasma generating section 116. When the sample is transferred into the plasma generating section 116, the sample is activated by plasma, and discharged forward together with the plasma from the aperture 118 of the plasma generating section 116. While the sample mainly exists in the central section of the cylindrical plasma generating section 116, the sample is discharged forward from the aperture 118. Therefore, the sample passes through the sampler hole, proceeds to the mass spectroscope, and is mass-analyzed. Most gas or most plasma in the plasma generating section 116 is blocked by the sampler and discharged in the direction of the outer circumference. The liquid cools the plasma gas tube body 112, discharged in the direction of the outer circumference, and becomes the liquid curtain 134. The liquid curtain 134 prevents unnecessary gas from being mixed in the plasma.

### Spectroscopic analysis

Spectroscopic analysis is performed, for example, by using the plasma source 110, an unshown condenser such as a lens, and an unshown spectroscopic analyzer. The spectroscopic analyzer is mainly arranged on a side section of the plasma source 110, condenses light emitted from a sample workpiece in the plasma by the condenser, and performs spectroscopic analysis. The spectroscopic analysis is performed by transferring a sample to be analyzed with carrier gas to the plasma generating section 116. Then, plasma gas is introduced to the plasma generating section 116, while being rotated inside the plasma gas tube body 112 through the lead pipe 114. Part of the plasma gas is changed into plasma by the plasma generating apparatus 128 in the plasma generating section 116. When the sample is transferred into the plasma generating section 116, the sample is activated by the plasma, and discharged forward together with the plasma from the aperture 118 of the plasma generating section 116. The sample mainly exists in the central section of the cylindrical plasma generating section 116, and the sample is discharged outside from the aperture 118 while emitting inherent light. After being discharged, while the sample emits inherent light outside of the plasma generating section 116, the sample exists together with the plasma gas in a given time. Then, the inherent light of the sample is condensed by the condenser, the condensed light is transferred to the spectroscopic analyzer, and spectroscopic analysis is performed. The liquid cools the plasma gas tube body 112, is discharged in the direction of the outer circumference, and becomes the liquid curtain 134. The liquid curtain 134 prevents unnecessary gas from being mixed in the plasma.

### Decomposition processing

The plasma source 110 can perform decomposition processing for a material such as PCB and CFC. The workpiece material is mixed in carrier gas or plasma gas, which is introduced in high temperature plasma, and thereby the material can be decomposed and defused. The liquid cools the plasma gas tube body 112, is discharged in the direction of the outer circumference, and becomes the liquid curtain 134. The liquid curtain 134 can prevent unnecessary gas from being mixed in the plasma.

As described above, in the embodiment of the invention, plasma is surrounded by the liquid curtain 134 to block the gas. Therefore, high purity processing is enabled in the air. Further, in the embodiment of the invention, for example, the following usable effects can be obtained. That is, a sample can be easily and simply cooled. Further, the wet processing and the dry processing can be performed for a workpiece sequentially, at once, or chronologically. Furthermore, the amount of plasma gas used can be decreased, plasma can be stabilized, a plasma torch can be lengthened, and the shape of the cooling torch section can be formed simply and inexpensively.

## Claims

1. A processing apparatus comprising:
a chamber;
a retaining means provided in the chamber for retaining a workpiece;
an active atom supplying means for supplying an active atom into the chamber; and
a chemical supplying means for supplying a chemical into the chamber, wherein dry processing by the active atom supplied from the active atom supplying means and wet processing by the chemical supplied from the chemical supplying means are performed for a surface of the workpiece.

2. The processing apparatus according to claim 1, wherein the active atom supplying means supplies the active atom into the chamber at an ambient pressure.

3. The processing apparatus according to claim 1 or claim 2, wherein the retaining means can rotate the retained workpiece, and
a supply port of the active atom supplying means is arranged opposite to the surface of the workpiece, and is provided movably in the direction of a radius from a rotation center of the workpiece.

4. The processing apparatus according to claim 3, wherein the supply port of the active atom supplying means and a supply port of the chemical supplying means are integrated.

5. The processing apparatus according to claim 1 or claim 2, wherein a supply port of the active atom supplying means is opposite to the surface of the workpiece, and has an area equal to or more than an area of the workpiece.

6. The processing apparatus according to claim 1 or claim 2, wherein the retaining means is provided capable of retaining a plurality of workpieces, and is provided capable of dipping the plurality of workpieces in the chemical.

7. The processing apparatus according to any of claim 1 to claim 6, wherein the chemical contains sulfuric acid, and the active atom contains a hydrogen atom or an oxygen atom.

8. The processing apparatus according to any of claim 1 to claim 6, wherein the chemical contains ammonium hydroxide, hydrochloric acid, sulfuric acid, or hydrofluoric acid, and the active atom contains an oxygen atom.

9. The processing apparatus according to any of claim 1 to claim 6, wherein the workpiece contains a semiconductor on a processing surface, and the active atom contains a hydrogen atom.

10. The processing apparatus according to any of claim 1 to claim 6, wherein the chemical contains phosphoric acid, and the active atom contains a fluorine atom.

11. The processing apparatus according to any of claim 1 to claim 6, wherein the workpiece has a resist film on a processing surface, and the active atom contains a hydrogen atom or an oxygen atom, and the resist film of the workpiece is removed.

12. The processing apparatus according to any of claim 1 to claim 11, wherein the active atom supplying means generates the active atom by using inductively coupled plasma method or microwave plasma method.

13. A processing method, wherein dry processing by an active atom supplied from an active atom supplying means and wet processing by a chemical supplied from a chemical supplying means are performed at the same time or sequentially for a surface of a workpiece retained in a chamber.

14. The processing method according to claim 13, wherein the dry processing is performed at an ambient pressure.

15. The processing method according to claim 13 or claim 14, wherein while the chemical supplied from the chemical supplying means is supplied for a whole surface of the workpiece, the active atom supplied from the active atom supplying means is supplied for part of the surface of the workpiece.

16. The processing method according to any of claim 13 to claim 15, wherein the active atom is supplied by moving a supply port of the active atom supplying means from a rotation center of the workpiece in the direction of a radius, while the workpiece is rotated.

17. The processing method according to claim 13 or claim 14, wherein the workpiece is dipped in the chemical supplied from the chemical supplying means in the chamber, and
the active atom is supplied into an atmosphere in the chamber while the chemical is drained.

18. The processing method according to any of claim 13 to claim 17, wherein the chemical contains sulfuric acid, and the active atom contains a hydrogen atom or an oxygen atom.

19. The processing method according to any of claim 13 to claim 17, wherein the chemical contains ammonium hydroxide, hydrochloric acid, sulfuric acid, or hydrofluoric acid, and the active atom contains an oxygen atom.

20. The processing method according to any of claim 13 to claim 17, wherein the workpiece contains a semiconductor on a processing surface, and the active atom contains a hydrogen atom.

21. The processing method according to any of claim 13 to claim 17, wherein the chemical contains phosphoric acid, and the active atom contains a fluorine atom.

22. The processing method according to any of claim 13 to claim 17, wherein the workpiece has a resist film on a processing surface, and the active atom contains a hydrogen atom or an oxygen atom, and the resist film of the workpiece is removed.

23. A plasma source comprising:
a plasma generating section for generating plasma; and
a liquid supplying section for forming a liquid curtain, wherein the liquid supplying section covers at least part of the plasma generated in the plasma generating section with the liquid curtain.

24. The plasma source according to claim 23, wherein the liquid supplying section covers plasma downstream of the plasma generating section with the liquid curtain.

25. The plasma source according to claim 23 comprising:
a gas/mist supplying section for supplying gas or mist into the plasma or a surrounding area thereof.

26. The plasma source according to claim 23, wherein the plasma generating section has an aperture, and
the liquid supplying section discharges liquid from a surrounding area of the aperture, and covers plasma in front of the aperture with the liquid curtain.

27. The plasma source according to claim 23, wherein the plasma generating section has an aperture,
an opposing member arranged opposite to the aperture is provided, and
the liquid supplying section discharges liquid from a surrounding area of the aperture toward the opposing member, and covers plasma in front of the aperture with the liquid curtain and the opposing member.

28. The plasma source according to claim 23, wherein the plasma generating section has an aperture, and
the liquid supplying section flows liquid to a surrounding area of the plasma generating section to cool the plasma generating section, discharges the liquid from a surrounding area of the aperture, and covers plasma in front of the aperture with the liquid curtain.

29. A processing apparatus comprising:
a plasma generating section for generating plasma;
a liquid supplying section for covering at least part of the plasma generated in the plasma generating section with a liquid curtain; and
a retaining section arranged opposite to the liquid supplying section for retaining a workpiece, wherein the workpiece retained by the retaining section is processed by the plasma covered with the liquid curtain.

30. The processing apparatus according to claim 29, wherein the workpiece is provided with dry processing by the plasma, and is provided with wet processing by liquid supplied from the liquid supplying section or a chemical injection apparatus.

31. The processing apparatus according to claim 29, wherein the plasma generating section has an aperture, and
the retaining section rotates the workpiece.

32. The processing apparatus according to claim 29, wherein the plasma generating section has an aperture, and
the liquid supplying section discharges liquid from a surrounding area of the aperture, and covers plasma in front of the aperture with the liquid curtain.

33. The processing apparatus according to claim 29 comprising:
the plasma generating section;
the liquid supplying section; and
a chamber for accommodating the retaining section.

34. A processing method, wherein a liquid curtain is formed, liquid or mist is supplied into the liquid curtain, plasma is formed in the liquid curtain, and thereby a workpiece is processed.

35. A processing method, wherein a workpiece is provided with dry processing by plasma covered with a liquid curtain, and the workpiece is provided with wet processing by liquid or mist.
